**Europäisches Patentamt**

(19) **European Patent Office**

**Office européen des brevets**

(11) Numéro de publication: **0 019 549**

**A1**

# (12) DEMANDE DE BREVET EUROPEEN

(21) Numéro de dépôt: **80400669.0**

(22) Date de dépôt: **14.05.80**

(51) Int. Cl.³: **C 23 C 11/00**
**H 05 H 1/46**

(30) Priorité: **18.05.79 FR 7912712**

(43) Date de publication de la demande:
**26.11.80 Bulletin 80/24**

(84) Etats Contractants Désignés:
**DE GB NL**

(71) Demandeur: **"THOMSON-CSF"- SCPI
173, Boulevard Haussmann
F-75360 Paris Cedex 08(FR)**

(72) Inventeur: **Boulanger, Philippe
"THOMSON-CSF" SCPI - 173, bld Haussmann
F-75360 Paris Cedex 08(FR)**

(72) Inventeur: **Kaplan, Daniel
"THOMSON-CSF" SCPI - 173, bld Haussmann
F-75360 Paris Cedex 08(FR)**

(72) Inventeur: **Mourier, Georges
"THOMSON-CSF" SCPI - 173, bld Haussmann
F-75360 Paris Cedex 08(FR)**

(74) Mandataire: **Benichou, Robert et al,
"THOMSON-CSF" - SCPI 173 bld Haussmann
F-75360 Paris Cedex 08(FR)**

(54) **Dispositif hyperfréquence pour le dépôt de films minces sur des solides.**

(57) L'invention se rapporte aux dispositifs pour le dépôt de films minces sur des solides.

Elle a pour objet un dispositif comportant des moyens de formation d'une zone d'excitation HF (1 et 2) dans une enceinte allongée (4), une pompe à vide (6) dont la prise est située à une extrémité de l'enceinte, un dispositif permettant d'injecter dans l'enceinte, à proximité mais en dehors de la zone d'excitation HF, un mélange de gaz comportant au moins un composé du corps à déposer ; le solide sur lequel doit être effectué le dépôt est placé dans l'enceinte ; la zone de dépôt sur ce solide est limitée à une zone de l'enceinte extérieure à la zone d'excitation HF dans laquelle le mélange gazeux est en quasi-totalité décomposé par les particules énergétiques émises dans cette zone.

Application, notamment, à la fabrication de collecteurs d'énergie solaire, le dépôt métallique absorbant étant effectué au moyen du dispositif suivant l'invention sur la paroi intérieure d'un tube de verre formant enceinte.

EP 0 019 549 A1

./...

Croydon Printing Company Ltd.

FIG. 1

1

# DISPOSITIF HYPERFREQUENCE POUR LE DEPOT DE FILMS MINCES SUR DES SOLIDES

L'invention se rapporte au domaine des techniques de dépôt de films minces et a plus particulièrement pour objet un dispositif hyperfréquence pour le dépôt de tels films minces sur des solides.

De nombreuses applications utilisent couramment des dépôts en couches minces de divers matériaux sur des solides. Pour obtenir de tels dépôts, il est possible d'exploiter des phénomènes thermiques dans différents types de fours, mais aussi des décharges électriques dans des gaz appropriés en basse pression, et en particulier des décharges à haute fréquence. Il existe actuellement toute une gamme de dispositifs de dépôt fonctionnant à différentes fréquences, de O à 50 MHz, pour les dépôts en couches minces de divers matériaux sur différents types de supports.

Par exemple, pour obtenir des dépôts métalliques, il est possible d'utiliser une cloche à vide. Dans cette cloche à vide, un gaz rare est introduit sous une pression convenable, par exemple de l'Argon sous une pression de $10^{-2}$ Torr ; deux plateaux horizontaux circulaires distants d'une trentaine de centimètres servent à exciter un champ électrique à un fréquence de 13,56 MHz, par exemple à partir d'un générateur de puissance 500 W. Le matériau sur lequel doit être effectué le dépôt est fixé au plateau supérieur, et des plaques de métal, or, platine, titane, tungstène etc ... sont placées sur le plateau inférieur. Les atomes métalliques frappés par des ions argon, $A^+$, produits par la décharge du gaz présent dans la cloche, se déposent sur l'échantillon à traiter.

2

Les dépôts ainsi obtenus peuvent être de l'ordre de un à quelques centaines d'Angströms par minute et les propriétés de tels dépôts peuvent être très bonnes, tant en ce qui concerne la pureté du dépôt que son adhérence sur l'échantillon.

Dans d'autres types de dispositifs, un composé métallique gazeux est introduit, sous une pression convenable, dans une enceinte dans laquelle est placé le matériau sur lequel doit être effectué le dépôt. Une décharge électrique de fréquence convenable permet, à partir du composé métallique gazeux, de libérer du métal par décomposition du mélange gazeux. Comme indiqué ci-dessus, la gamme de fréquence des décharges utiles s'étend jusqu'à une cinquantaine de MHz.

Par ailleurs, il existe d'autes types de dispositifs utilisant des décharges hyperfréquences pour obtenir un effet de nettoyage de surface par érosion. Pour cela, on utilise le bombardement d'espèce chimiquement neutres (gaz rares). Pour obtenir cet effet, ce bombardement est effectué par des particules de très haute énergie. De telles décharges hyperfréquences permettent le bombardement de surfaces à nettoyer par érosion par des ions qui peuvent atteindre des énergies très élevées ; de l'ordre du kV par exemple.

L'invention a pour objet un dispositif pour le dépôt de films minces sur des matériaux solides, comportant des moyens de production, par décharge hyperfréquence, d'électrons rapides utilisés à l'extérieur de leur zone de production pour dissocier un composant gazeux comportant le corps à déposer, le matériau a recouvrir étant placé dans une zone où le composant gazeux est dissocié mais en dehors de la zone d'excitation HF intense.

Suivant l'invention, le dispositif hyperfréquence pour le dépôt de films minces sur des solides est caractérisé en ce qu'il comporte une enceinte allongée, des moyens d'excitation d'un champ d'électromagnétique crée dans une zone limitée de l'enceinte pour former un plasma, une pompe à vide, des moyens d'injection dans cette enceinte d'un composé gazeux susceptible de libérer après décomposition les particules à déposer, la pompe à vide et les moyens d'injection ayant des prises disposées sur l'enceinte respectivement de part et d'autre du plasma, le débit d'injection du composé gazeux et la pression dans l'enceinte étant tels que la plus grande partie du composé gazeux est décomposée entre la prise d'injection et la zone d'excitation HF, le matériau sur lequel doit être effectué le dépôt étant placé dans l'enceinte, dans la zone de décomposition du gaz.

L'invention sera mieux comprise et d'autres caractéristiques apparaîtront à l'aide de la description qui suit en référence aux figures annexées.

La figure 1 représente un premier mode de réalisation du dispositif hyperfréquence pour le dépôt de films minces comportant un générateur hyperfréquence alimentant un guide d'onde pour l'excitation HF.

La figure 2 représente un second mode de réalisation comportant un condensateur de géométrie appropriée pour l'excitation hyperfréquence.

La figure 3 représente un autre mode de réalisation du dispositif suivant l'invention comportant une enceinte en forme de nappe.

La figure 4 représente en coupe, un autre mode

4

de réalisation du dispositif suivant l'invention.

Le dispositif objet de l'invention permet de produire des électrons à haute énergie qui permettent la dissociation efficace de composants gazeux, et le dépôt des produits de décomposition sur des surfaces situées en dehors de la zone de production des particules energétiques. Ainsi, le matériau à traiter étant situé en dehors de la zone de bombardement ionique, l'effet utilisé dans certains types de dispositifs pour nettoyer les surfaces de matériaux par érosion ne peut pas se produire. Par contre la dissociation des molécules de gaz étant effectuée très facilement au moyen des particules énergétiques provenant de la zone excitée, les vitesses de dépôt de matériaux susceptiblesd'être obtenues sont très grandes : par exemple, pour des dépôts de silicium on a obtenu des vitesses de dépôt de l'ordre du demi-micron par minute.

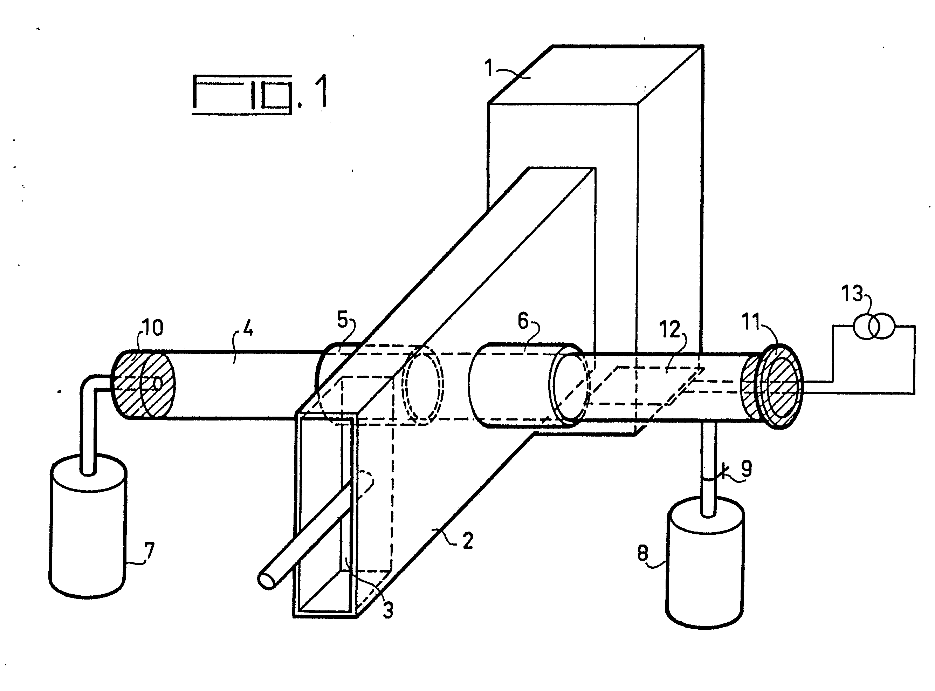

Le dispositif représenté sur la figure 1 comporte un générateur hyperfréquence accordable, 1, susceptible de fournir une puissance de quelques centaines de watts à une fréquence de l'ordre du millier de MHz : par exemple 200 watts à 1270 MHz. Ce générateur hyperfréquence excite un guide d'onde rectangulaire 2 de basse impédance terminé par un piston de court-circuit mobile 2. Ce guide d'onde est traversé par un tube de verre 4 dont l'axe est parallèle au champ électrique dans le guide d'onde. Le guide est, de plus, muni de deux manchons 5 et 6 entourant le tube de verre au niveau de l'ouverture pratiquée dans le guide d'onde. Ces deux manchons permettent d'éviter la fuite de champ électro-magnétique. Le tube de verre 4 peut en outre coulisser librement dans le guide d'ondes et les manchons associés.

5

L'une des extrémités du tube de verre est reliée à une pompe à vide 7. Sur l'autre partie du tube une ouverture est prévue à laquelle est branchée une réserve de mélange gazeux utilisé, 8. Le débit du mélange gazeux introduit dans le tube est réglé au moyen d'une vanne réglable 9. Les deux extrémités du tube sont munies de bouchons démontables 10 et 11. Ces bouchons démontables permettent d'introduire dans le tube les éléments sur lesquels on souhaite obtenir les dépôts. Ils permettent également d'introduire dans l'enceinte des supports chauffants à résistance, 12, connectés à une source de courant extérieure 13.

Un tel dispositif permet d'obtenir un dépôt soit sur un élément déposé à l'intérieur du tube, soit directement sur la paroi interne du tube lui-même.

Ce dispositif fonctionne de la manière suivante. A la mise en marche du dispositif, l'ionisation est obtenue à l'aide d'une bobine de Ruhmkorff. La décharge est entretenue grâce au guide d'onde 2 alimenté par le générateur hyperfréquence 1. L'ionisation est maintenue dans un intervalle de pression assez grand, de $10^{-4}$ Torr à plusieurs dizaines de Torr. Les particules énergétiques, électrons, provenant de la partie du tube situé dans le guide d'onde, partie du tube dans laquelle est formé le plasma, sont émises à l'extérieur de la zone excitée et permettent la décomposition du composé gazeux avec une grande efficacité. Compte tenu de la grande énergie de ces particules, une très grande quantité du composé gazeux est dissociée avant d'atteindre le guide d'onde, et donc la zone du plasma. Cette dissociation ne peut cependant se maintenir que si le libre parcours des molécules de gaz n'est pas trop court ; c'est-à-dire lorsque la pression n'est pas supérieure à quelques dizièmes de Torr (typiquement 0,3 Torr).

Les produits condensables se déposent alors entre le guide d'onde et la prise utilisée pour l'injection du composé gazeux. A l'intérieur du guide d'onde, aucun dépôt important ne peut être contrôlé du fait du bombardement ionique des parois du tube situées dans cette zone ; des traces de ce bombardement peuvent par contre être observées dans cette zone.

Un avantage présenté par un tel dispositif est que, le dépôt étant obtenu à l'extérieur du champ hyperfréquence, ce dépôt n'est pas susceptible de s'échauffer exagéremment du fait de ce champ hyperfréquence et, le dépôt n'empêche pas la propagation électromagnétique. En aval du guide d'ondes, il est possible d'observer un dépôt de faible épaisseur par rapport à celui obtenu en amont du guide par rapport au point d'injection du composé gazeux. Ce dépôt résulte de la petite quantité de composé gazeux subsistant dans la partie aval du tube.

Pour obtenir un dépôt sur un élément solide de petites dimensions disposé à l'intérieur du tube, l'élément est placé immédiatement en amont du guide d'ondes, et la prise d'injection du composé gazeux est prévue immédiatement en amont de l'élément. Ainsi, la surface de la paroi interne de l'enceinte sur laquelle le dépôt s'effectue en même temps que sur l'élément, est minimisée.

Par contre, pour obtenir un dépôt sur toute la paroi interne du tube de verre, la prise d'injection du composé gazeux est placée à l'extrémité du tube opposée à l'extrémité à laquelle est disposée la pompe à vide. Lors de la mise en marche du dispositif le tube est placé de telle manière que la prise d'injection du composé gazeux soit immédiatement au voisinage du plasma. Puis, au cours du fonctionnement, le tube coulisse dans le guide d'ondes et les manchons associés de façon à déplacer la zone d'excitation HF par rapport au tube, la zone de dépôt variant corrélativement. Ainsi toute la paroi interne du tube de verre peut être recouverte du matériau souhaité.

Le dispositif a été particulièrement expérimenté dans le but d'obtenir un dépôt de silicium. Pour cela, le composé gazeux utilisé est formé de silane additionné d'hydrogène ou d'argon. Le générateur hyperfréquence utilisé fournissant un signal à fréquence 1270 MHz, le diamètre de l'enceinte associée a été choisi égal à 3,9 cm, la longueur d'onde hyperfréquence étant de 23,62 cm. En effet, le diamètre du tube ne doit pas dépasser une certaine fraction de la longueur d'onde, 1/6 ou à la rigueur 1/4 de longueur d'onde. Le générateur hyperfréquence utilisé étant accordable, il a été montré qu'une variation de fréquence de plus ou moins 150 MHz n'entraine pas de modifications appréciables dans le fonctionnement du dispositif. Il a été ainsi obtenu des dépôts de plusieurs dizaines de microns bien homogènes, d'aspect métallique brillant, sans clivage. Il a même été possible d'obtenir des couches compactes atteignant 0,6 mm d'épaisseur, en des temps relativement courts, un tel dispositif ayant en effet une grande vitesse de dépôt, jusqu'à quelques milliers d'Angströms par minute.

Les valeurs numériques indiquées ci-dessus, et qui correspondent seulement à un mode de réalisation particulier du dispositif, peuvent être facilement adaptées en fonction d'une part de la vitesse de dépôt souhaitée

8

et en fonction d'autre part de la surface sur laquelle on souhaite effectuer ce dépôt. En particulier, il est possible de travailler dans une bande de fréquence différente. Il n'y a pas de limite vers les hautes fréquences. Il est connu que les densités de gaz et d'électrons permises croissent à peu près comme le carré de la fréquence du générateur utilisé, mais les dimensions de l'enceinte utilisable diminuent : les systèmes utilisant de très hautes fréquences conviennent bien pour des dépôts rapides sur de petites surfaces. Du côté des fréquences plus basses, la limite est donnée par les amplitudes trop grandes des mouvements électroniques : au-dessous de quelques dizaines de MHz, les amplitudes nécessaires pour que les électrons atteignent une énergie cinétique d'une vingtaine d'électrons volts sont de plusieurs cm, ce qui oblige à diminuer la pression. Pour une enceinte formée d'un tube de diamètre 20 cm, une fréquence de 200 MHz est bien adaptée. Il y a donc lieu de faire un compromis entre les dimensions des éléments sur lesquels on souhaite obtenir les dépôts et la vitesse de dépôt en fonction des besoins de l'application.

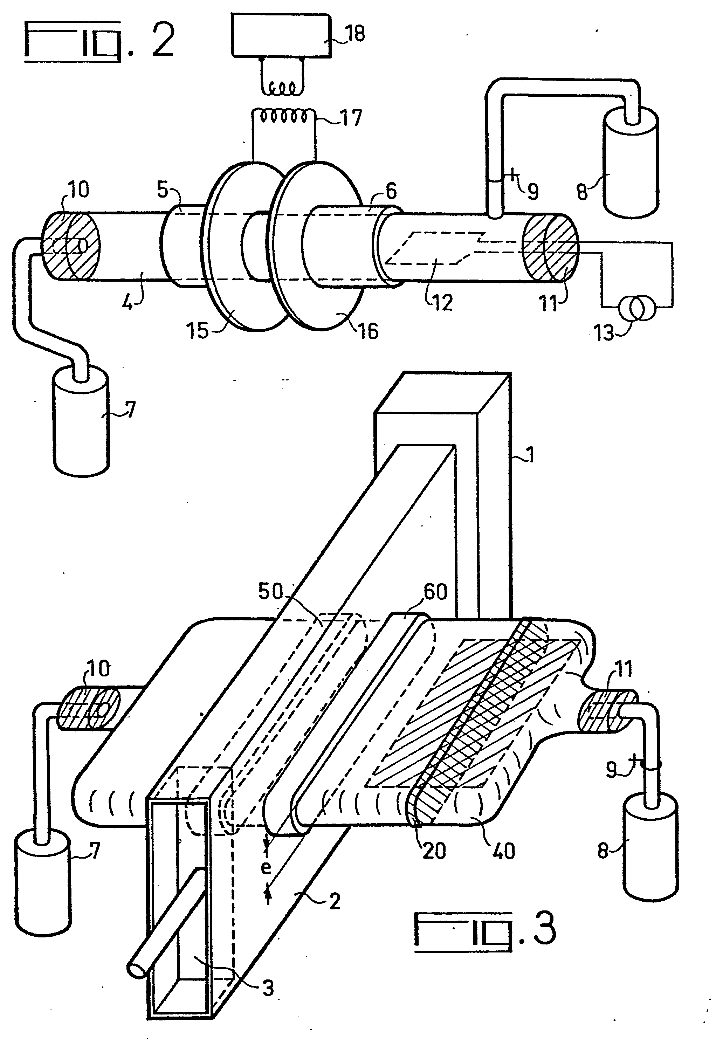

Pour les systèmes travaillant à fréquence assez basse, de l'ordre de quelques dizaines de MHz, les guides d'ondes nécessaires deviennent très grands. Il est alors préférable d'utiliser un autre moyen d'excitation HF. Le dispositif représenté sur la figure 2 correspond à un second mode de réalisation du dispositif suivant l'invention et est particulièrement utilisable aux fréquences relativement basses (inférieures à 100 MHz par exemple). Sur cette figure, les mêmes éléments que sur la figure 1 ont été désignés par les mêmes repères. Le dispositif comporte donc une enceinte 4 formée d'un tube de verre aux deux extrémités duquel sont disposées respectivement une pompe à vide, 7, dont la prise est prévue sur un bouchon démontable 10 fermant le tube, une réserve de gaz 8 disposée à l'autre extrémité permettant d'injecter le composant gazeux dans le tube de verre au moyen d'une vanne réglable 9, cette seconde extrémité du tube étant également fermée par un bouchon démontable 11.

Un support chauffant 12 alimenté par un générateur de courant 13 est également prévu. La décharge à haute fréquence est obtenue au moyen d'un condensateur formé de deux anneaux 15 et 16 reliés à une bobine d'inductance 17 excitée par un générateur 18 reliée à une seconde bobine 19. Les deux anneaux formant le condensateur sont prolongés, comme l'était précédemment le guide d'onde, par deux manchons 5 et 6. Ce dispositif permet comme le dispositif représenté sur la figure 1, de créer un plasma dans une zone limitée d'une enceinte. Cette enceinte a été représenté sous forme de tube cylindrique. Cette forme correspond à un mode de réalisation. Mais il est également possible d'utiliser une région d'interaction entre la zone d'excitation HF et le composé gazeux non plus cylindrique mais en forme de nappe.

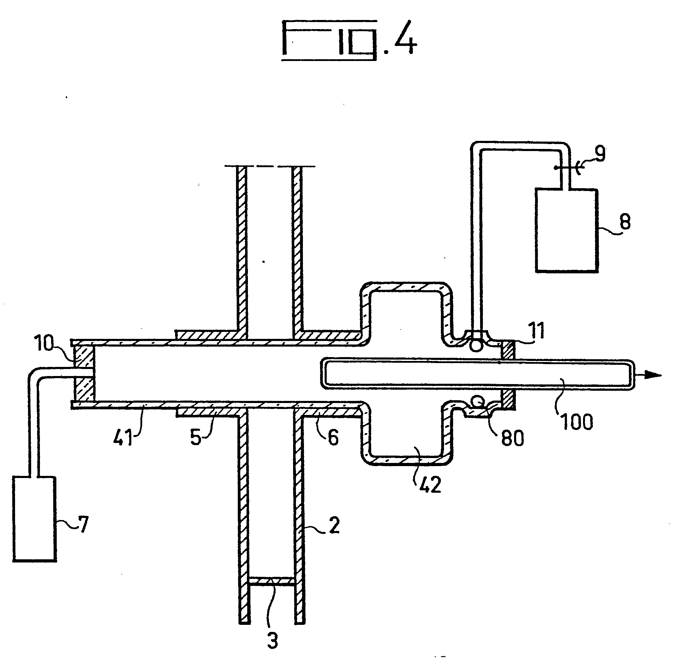

Un mode de réalisation d'un dispositif, comportant une enceinte plate, dans lequel l'excitation est obtenue au moyen d'un guide d'onde est représenté sur la figure 3. Comme précédemment, les éléments semblables à ceux décrits précédemment sur l'une des figures 1 ou 2 sont désignés par les mêmes repères. Ce dispositif comporte donc un générateur hyperfréquence 1 associé à un guide d'onde à section rectangulaire, 2,

10

fermé par un piston de court-circuit mobile 3. L'enceinte plate s'étendant suivant la direction de propagation de l'onde électromagnétique dans le guide. En effet, la règle de dimensionnement de l'enceinte par rapport à la longueur d'onde du signal hyperfréquence mentionnée ci-dessus concernant le diamètre maximum du tube susceptible d'être utilisé, ne s'impose en fait que dans un plan orthogonal à la direction de propagation de l'onde électromagnétique. Par conséquent il est possible d'utiliser une enceinte dont l'épaisseur e n'est pas supérieure au quart de la longueur d'onde de l'onde hyperfréquence, la longueur de cette enceinte suivant la direction de propagation dans le guide d'onde n'étant pas limitée.

Comme dans les modes de réalisation précédents, l'enceinte est fermée par deux bouchons démontables 10 et 11, l'un communiquant avec une pompe à vide 7 et l'autre avec une réserve de composant gazeux, 8, dont le débit est réglable au moyen d'une vanne 9. La nappe peut être ouverte pour permettre l'introduction des objets à recouvrir, un joint démontable étanche au vide, 20 étant prévu. Pour empêcher la fuite de champ électromagnétique du guide d'onde, deux manchons 50 et 60, comportant éventuellement des pièges, sont associés à ce guide d'onde et entourent la nappe 40. Un tel dispositif est particulièrement adapté au revêtement d'objets plans, par exemple pour l'application de couches passivantes. Comme dans les modes de réalisation précédents, l'enceinte est susceptible de coulisser par rapport au plasma de façon à déplacer la zone de décomposition du composé gazeux dans l'enceinte ; un tel dispositif permettant de recouvrir du dépôt souhaité des objets étendus.

11

La figure 4 représente, en coupe, un autre mode de réalisation du dispositif suivant l'invention, dans lequel l'enceinte est fixe par rapport à la région d'excitation HF, l'objet à recouvrir étant susceptible de coulisser par rapport à l'enceinte et donc par rapport à la zone de dépôt qui elle est fixe.

Le dispositif comporte comme précédemment un guide d'onde 2, fermé par un piston mobile 3, susceptible d'être alimenté par un générateur hyperfréquence non représenté. Deux manchons 5 et 6 sont également prévus ainsi qu'une pompe à vide 7 dont la prise est placée à une extrémité de l'enceinte 41.

L'objet à recouvrir est un tube 100, le dépôt devant être effectué sur la paroi extérieure. Ce tube est susceptible de coulisser à travers un bouchon 11, le joint entre le bouchon et le tube étant étanche. . Le composé gazeux est stocké dans une réserve 8 et injecté dans l'enceinte 41 par une distribution annulaire 80 permettant d'uniformiser la distribution du composé gazeux dans l'enceinte. La région de dépôt 42 dans laquelle s'effectue la décomposition du gaz peut avoir une forme quelconque.

Pour obtenir un dépôt très uniforme, il est possible de régler le dispositif de façon que la vitesse de dépôt ne soit pas trop rapide. En effectuant de plus un balayage, l'objet à recouvrir étant déplacé à vitesse constante par rapport à la zone de décomposition, soit par déplacement de l'enceinte dans laquelle l'objet est fixe, soit par déplacement de l'objet lui-même, des dépôts bien homogènes et sans clivage peuvent être obtenus. La partie qui vient d'être couverte doit se déplacer en s'éloignant de la zone d'excitation HF.

12

De plus, en appliquant un champ magnétique suivant l'axe du tube formant enceinte, il est possible de modifier la répartition et la composition du dépôt. En effet, dans ce cas, les ions et les électrons étant piégés le long des lignes de champ magnétique, et ces lignes de champ étant dirigées selon l'axe du tube, il est possible de diminuer la pression par rapport à la pression nécessaire en l'absence de champ. En travaillant à plus basse pression, il est alors possible de modifier la composition du dépôt par rapport à ce qu'elle serait à pression plus élevée et de diminuer en même temps la vitesse de dépôt.

Le dispositif suivant l'invention est notamment applicable à l'obtention de dépôts absorbants sur des tubes de verre pour les systèmes de conversion d'énergie solaire en énergie thermique.

Dans le cas où le composé gazeux utilisé est un mélange, de silane, d'hydrogène et d'argon, le dépôt de silicium amorphe obtenu contient de l'hydrogène. En effectuant un traitement supplémentaire, de tels dépôts peuvent être utilisés dans des convertisseurs photovoltaïques, dans le domaine des panneaux à cellules solaires : le silane, $SiH_4$, se décompose à la suite des chocs électroniques en $SiH_2$ et hydrogène. Si les chocs sont plus nombreux, les molécules de $SiH_2$ peuvent également donner lieu à des molécules de SiH. Le dépôt obtenu a donc une teneur en hydrogène variable en fonction des conditions de fonctionnement du dispositif, pression, température etc ... Il est donc possible de régler les différents paramètres du dispositif de façon à obtenir une vitesse de dépôt aussi grande que possible. Puis, si nécessaire pour obtenir un dépôt présentant les qualités souhai-

13

tées quant à sa teneur en hydrogène, un traitement supplémentaire sera effectué, soit un chauffage pour diminuer la teneur en hydrogène, soit un traitement en atmosphère d'hydrogène atomique pour augmenter cette teneur.

L'invention n'est pas limitée aux modes de réalisation du disposittif précisémment décrits et représentés. En particulier, pour les dépôts sur des tubes, les modes de réalisation ont été décrits avec, soit un déplacement de la zone de décomposition du gaz par rapport au tube, soit un déplacement du tube par rapport à la zone de décomposition. Il est également possible de combiner ces deux déplacements. De plus, pour créer dans l'enceinte une zone d'excitation HF, un guide à section rectangulaire a été décrit, mais cette forme n'est pas limitative. De plus, en ce qui concerne les dépôts, de nombreux types de dépôts peuvent être obtenus. Il est possible par exemple de déposer du nitrure de bore, et de passiver divers matériaux.

14

## REVENDICATIONS

1. Dispositif hyperfréquence pour le dépôt de films minces sur des solides, caractérisé en ce qu'il comporte une enceinte allongée, des moyens d'excitation d'un champ électromagnétique hyperfréquence, HF, créé dans une zone limitée de l'enceinte, une pompe à vide, des moyens d'injection dans cette enceinte d'un composé gazeux susceptible de libérer après décomposition les particules à déposer, la pompe à vide et les moyens d'injection ayant des prises disposées sur l'enceinte respectivement de part et d'autre de la zone d'excitation HF, le débit d'injection du composé gazeux et la pression dans l'enceinte étant tels que la plus grande partie du composé gazeux est décomposée dans une zone comprise entre la prise d'injection et la zone d'excitation, le matériau sur lequel doit être effectué le dépôt étant placé dans l'enceinte, dans cette zone de décomposition du gaz.

2. Dispositif selon la revendication 1, caractérisé en ce que les moyens d'excitation comportent un guide d'onde hyperfréquence et un générateur hyperfréquence associé, l'enceinte allongée traversant le guide d'onde de façon à créer une zone d'excitation dans la région commune à l'enceinte et au guide d'onde.

3. Dispositif selon la revendication 1, caractérisé en ce que les moyens d'excitation comportent un condensateur formé d'électrodes parallèles traversées par l'enceinte allongée, une bobine d'excitation reliée aux électrodes du condensateur et un générateur haute fréquence alimentant le circuit oscillant ainsi formé pour créer une zone d'excitation HF dans la région commune au condensateur et à l'enceinte allongée.

15

4. Dispositif selon l'une quelconque des revendications 2 ou 3, caractérisé en ce que l'enceinte allongée est un tube dont l'axe est parallèle au champ électrique dans la zone d'excitation HF.

5. Dispositif selon la revendication 4, caractérisé en ce que, pour effectuer un dépôt sur la paroi interne du tube formant enceinte, des moyens sont présus pour que le tube coulisse par rapport à la zone d'excitation HF, l'extrémité du tube où est injecté le composé gazeux étant placée initialement au voisinage de la zone d'excitation HF dans la zone de décomposition puis éloignée, les parois internes du tube défilant ainsi dans la zone de décomposition.

6. Dispositif selon la revendication 4, caractérisé en ce que, pour effectuer un dépôt sur la surface extérieure d'un matériau solide, l'enceinte comporte des moyens d'introduction du matériau dans cette enceinte, et éventuellement des moyens de déplacement du matériau par rapport à la zone d'excitation HF et à la zone adjacente de décomposition du composé gazeux.

7. Dispositif selon l'une quelconque des revendications précédentes, caractérisé en ce que des moyens de chauffage reliés à une source extérieure sont placés à l'intérieur de l'enceinte.

FIG. 1

0019549

Fig. 2

Fig. 3

# Fig.4

0019549

**Office européen des brevets**

# RAPPORT DE RECHERCHE EUROPEENNE

Numéro de la demande

EP 80 40 0669

| | | | CLASSEMENT DE LA DEMANDE (Int. Cl. 3) |
|---|---|---|---|
| **DOCUMENTS CONSIDERES COMME PERTINENTS** | | | |
| Catégorie | Citation du document avec indication, en cas de besoin, des parties pertinentes | Revendica-tion concernée | C 23 C 11/00 H 05 H 1/46 |
| A | FR - A - 2 380 232 (NORTHERN TELE-COM) | | |
| A | FR - A - 1 442 502 (INT. STANDARD) | | |
| A | US - A - 4 138 306 (K. NIWA) | | |
| A | DE - A - 2 656 821 (L.F.E.) | | |
| A | INSTRUMENTS AND EXPERIMENTAL TECHNIQUES, vol. 18, no. 4, II 1975, Plenum Publishing Corp. NEW YORK (US) N.A. MESHCHERYAKOV et al.:"Plasma-chemical installation for vacuum deposition of thin films" pages 1278-1280 | | |
| | | | **DOMAINES TECHNIQUES RECHERCHES (Int. Cl. 3)** |
| A | JOURNAL OF THE ELECTROCHEMICAL SOCIETY, vol. 115, no. 10, octobre 1968 (US) O.A. WEINREICH et al.:"Optical and Electrical Properties of SiC Films Prepared in a Microwave Discharge" pages 1090-1092 | | C 23 C 11/00 H 05 H 1/46 |
| A | JOURNAL OF THE ELECTROCHEMICAL SOCIETY, vol. 113, no. 9, septembre 1966 (US) D.R. SECRIST et al.:"Deposition of Silica Films by the Glow Discharge Technique" pages 914-920 | | |

**CATEGORIE DES DOCUMENTS CITES**

X: particulièrement pertinent
A: arrière-plan technologique
O: divulgation non-écrite
P: document intercalaire
T: théorie ou principe à la base de l'invention
E demande faisant interférence
D document cité dans la demande
L document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 25-08-1980 | DEVISME |

OEB Form 1503.1 06.78